# EUROPEAN PATENT APPLICATION

(11) **EP 4 572 579 A1**
(43) Date of publication of application: **18.06.2025**
(21) Application number: 24218641.9
(22) Date of filing: 10.12.2024
(51) Int. Cl.: H10K 59/122, H10K 59/131, H10K 59/80

(54) **DISPLAY DEVICE AND METHOD OF FABRICATING THE SAME**

(30) Priority: 14.12.2023 KR 20230182216
(71) Applicant: Samsung Display Co., Ltd., Yongin-si, Gyeonggi-do 17113 (KR)
(72) Inventor: LEE, Jeong Seok, Yongin-si (KR); SUNG, Woo Yong, Yongin-si (KR); YANG, Hee Jun, Yongin-si (KR)
(74) Representative: Marks & Clerk LLP

(57) **Abstract**

A display device includes a substrate including light emission and non-light emission areas; an anode electrode on the light emission area; a light emitting layer on the anode electrode; a pixel defining layer on the non-light emission area and defining a first opening; a bank structure including first and second bank layers on the pixel defining layer, defining a second opening and including different conductive materials; an organic pattern on the bank structure and including a same material as the light emitting layer; a first encapsulation layer on the organic pattern; and an element passivation layer overlapping the non-light emission area and between the bank structure and the first encapsulation layer. The organic pattern includes a first side overlapping the light emission area and in contact with the first encapsulation layer, and a second side overlapping the non-light emission area and in contact with the element passivation layer.

## Description

### BACKGROUND

### 1. Field

The disclosure relates to a display device and a method of fabricating the display device.

### 2. Description of the Related Art

With the advancement of the information age, the demand for a display device for displaying an image has increased with various forms. For example, the display device has been applied to various electronic devices such as a smart phone, a digital camera, a laptop computer, a navigator and a smart television. The display device may be a flat panel display device such as a liquid crystal display device, a field emission display device and an organic light emitting display device. Among various types of flat panel display device, the light emitting display device includes a light emitting element in which each of the pixels of a display panel may self-emit light, thereby displaying an image even without a backlight unit that provides the display panel with light.

Recently, with the development of various electronic devices, there is an increasing demand for a display device of high resolution. In the case of the display device of high resolution, since high pixel integration is desired, an interval between light emitting elements, which overlap each light emission area, may be narrowed. Therefore, the display device of high resolution may be formed by a pattern process of forming individual pixels rather than a process of using a fine metal mask.

### BRIEF SUMMARY

Embodiments of the disclosure provide a display device that includes a bank structure and resolves moisture and oxygen permeation defects occurring during a fabricating process.

The display device according to embodiments of the disclosure includes a bank structure including different conductive materials, and an organic pattern and an electrode pattern on the bank structure. In such an embodiment, the bank structure may include a tip protruded toward a light emission area, such that light emitting elements spaced apart from each other may be formed in each light emission area even without a fine metal mask.

In an embodiment of the disclosure, a display device includes a substrate including a light emission area and a non-light emission area; an anode electrode on the light emission area of the substrate; a light emitting layer on the anode electrode; a pixel defining layer positioned on the non-light emission area of the substrate, wherein the pixel defining layer defines a first opening; a bank structure including first and second bank layers on the pixel defining layer, wherein the first and second bank layers define a second opening and include different conductive materials, respectively; an organic pattern on the bank structure, wherein the organic pattern includes a same material as the light emitting layer and is spaced apart from the light emitting layer; a first encapsulation layer on the organic pattern; and an element passivation layer overlapping the non-light emission area and between the bank structure and the first encapsulation layer in a direction perpendicular to the substrate, where the organic pattern includes a first side overlapping the light emission area and in contact with the first encapsulation layer, and a second side overlapping the non-light emission area and in contact with the element passivation layer.

In an embodiment, a display device may further include a cathode electrode on the light emitting layer, where the light emitting layer and the cathode electrode are in contact with a side of the first bank layer, and the second bank layer may include a tip more protruded toward the light emission area than the side of the first bank layer.

In an embodiment, a display device may further include an electrode pattern on the organic pattern, where the electrode pattern includes a same material as the cathode electrode, and is spaced apart from the cathode electrode.

In an embodiment, the electrode pattern may include a third side overlapping the light emission area and in contact with the first encapsulation layer, and a fourth side overlapping the non-light emission area and in contact with the element passivation layer.

In an embodiment, the second side of the organic pattern and the fourth side of the electrode pattern may be completely covered by the element passivation layer.

In an embodiment, the first opening may be completely surrounded by the second opening on a plane.

In an embodiment, a display device may further include a second encapsulation layer including an organic material on the first encapsulation layer, where the element passivation layer is in contact with the first encapsulation layer and the second encapsulation layer by overlapping the non-light emission area.

In an embodiment, the element passivation layer may be completely covered by the first encapsulation layer and the second encapsulation layer.

In an embodiment, a height of the first bank layer may be higher than a height of the second bank layer in a direction perpendicular to the substrate, and an electrical conductivity of the first bank layer is higher than and an electrical conductivity of the second bank layer.

In an embodiment, the first bank layer may include aluminium, and the second bank layer may include titanium.

In an embodiment, the element passivation layer may include at least one selected from silicon oxide, silicon oxynitride and silicon nitride.

In an embodiment, the organic pattern may be in contact with the second bank layer, and the element passivation layer may not overlap the light emission area.

In an embodiment, the element passivation layer may include a first passivation layer in contact with a second side of the organic pattern, and a second passivation layer between the organic pattern and the second bank layer in a direction perpendicular to the substrate.

In an embodiment, the first passivation layer may not overlap the light emission area, the second passivation layer may overlap the light emission area, and the second passivation layer may be in contact with the second bank layer.

In an embodiment, the element passivation layer may further include a third passivation layer between the second passivation layer and the organic pattern in a direction perpendicular to the substrate, and the second passivation layer and the third passivation layer may overlap a tip of the second bank layer.

In an embodiment of the disclosure, a display device includes a substrate including a light emission area and a non-light emission area; a first anode electrode on the light emission area of the substrate; a first light emitting layer on the first anode electrode; a pixel defining layer positioned on the non-light emission area of the substrate; a second anode electrode spaced apart from the first anode electrode with the pixel defining layer interposed therebetween; a second light emitting layer on the second anode electrode; a bank structure on the pixel defining layer, wherein the bank structure includes a first bank layer and a second bank layer; a first organic pattern positioned on the second bank layer, wherein the first organic pattern includes a same material as the first light emitting layer and is spaced apart from the first light emitting layer; a second organic pattern spaced apart from the first organic pattern in a direction parallel with the substrate, wherein the second organic pattern includes a same material as the second light emitting layer and is spaced apart from the second light emitting layer; a first encapsulation layer on the first organic pattern and the second organic pattern; a second encapsulation layer on the first encapsulation layer; and an element passivation layer between the first encapsulation layer and the second bank layer in a direction perpendicular to the substrate, where a portion of the element passivation layer, which is in contact with first organic pattern, and another portion of the element passivation layer, which is in contact with the second organic pattern, are spaced apart from each other in a direction parallel with the substrate.

In an embodiment, a display device may further include a first cathode electrode on the first light emitting layer; and a second cathode electrode on the second light emitting layer, wherein the first cathode electrode and the second cathode electrode are electrically connected to each other through the first bank layer.

In an embodiment, the element passivation layer may include a first passivation layer that is in contact with the first organic pattern, and a second passivation layer that is in contact with the second organic pattern, an upper surface of the second bank layer, which is directed toward the second encapsulation layer, includes: a first portion with which the first organic pattern is in contact; a second portion with which the second passivation layer is in contact; a third portion with which the first passivation layer is in contact; and a fourth portion with which the second encapsulation layer is in contact.

In an embodiment, the element passivation layer may include a first passivation layer overlapping the first organic pattern in a direction perpendicular to the substrate and a second passivation layer in contact with the second organic pattern, the second bank layer includes a first portion in contact with the first passivation layer, a second portion in contact with the second passivation layer, and a third portion in contact with the second encapsulation layer.

In an embodiment of the disclosure, a method of fabricating a display device includes forming a substrate including a light emission area and a non-light emission area, forming an anode electrode on the light emission area of the substrate, forming a sacrificial layer on the anode electrode, and forming a pixel defining material layer, a first bank material layer and a second bank material layer, which completely cover the sacrificial layer and the substrate; by forming a photoresist on the second bank material layer and forming a hole for exposing the sacrificial layer overlapping the anode electrode by removing a portion of the pixel defining material layer, a portion of the first bank material layer and a portion of the second bank material layer, which overlaps the anode electrode, through an etching process and then removing the sacrificial layer by removing an inner sidewall defining the hole through an etching process, to form a pixel defining layer, a first bank layer, and a second bank layer, where the second bank material layer forms a tip, which is more protruded toward the hole than a side of the first bank material layer; forming a first light emitting element by forming a light emitting layer, a cathode electrode and a first encapsulation layer on the anode electrode and the second bank layer, forming a hard mask at a portion overlapping the light emission area and a periphery of the light emission area, and removing the light emitting layer, the cathode electrode and the first encapsulation layer, which are positioned at a portion where the hard mask is not formed, through a wet etching process to form a first organic pattern and a first electrode pattern on the second bank layer; and forming an element passivation layer entirely on the hard mask, and removing the element passivation layer through an etching process using the hard mask as a mask, where the element passivation layer completely covers the first organic pattern and the first electrode pattern such that the first organic pattern and the first electrode pattern are not exposed.

At least some of the above and other features of the invention are set out in the claims.

In embodiments of the disclosure, a display device may include an element passivation layer that is in contact with the organic pattern and the electrode pattern, moisture and oxygen permeation defects caused during the fabricating process of the display device may be resolved.

The effects according to the embodiments of the disclosure are not limited to those mentioned above and more various effects are included in the following description of the disclosure.

### BRIEF DESCRIPTION OF THE DRAWINGS

The above and other features of embodiments of the disclosure will become more apparent by describing in detail embodiments thereof with reference to the accompanying drawings, in which:
FIG. 1 is a perspective view illustrating an electronic device according to an embodiment;
FIG. 2 is a perspective view illustrating a display device included in an electronic device according to an embodiment;
FIG. 3 is a schematic cross-sectional view illustrating a display device of FIG. 2;
FIG. 4 is a plan view illustrating arrangement of a light emission area in a display area of FIG. 3;
FIG. 5 is a schematic cross-sectional view illustrating a display layer taken along line X1-X1' of FIG. 4;
FIG. 6 is a schematic enlarged cross-sectional view illustrating a non-light emission area disposed between a first light emission area and a second light emission area in FIG. 5;
FIG. 7 is an enlarged cross-sectional view illustrating an area 'P' in FIG. 6;
FIG. 8 is a schematic enlarged cross-sectional view illustrating a non-light emission area disposed between a second light emission area and a third light emission area in FIG. 5;
FIG. 9 is an enlarged cross-sectional view illustrating an area 'T' in FIG. 8; and
FIGS. 10 to 24 are schematic cross-sectional views illustrating an embodiment of a method of fabricating a display layer shown in FIG. 5.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). For example, the term such as "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described in detail with reference to the accompanying drawings.

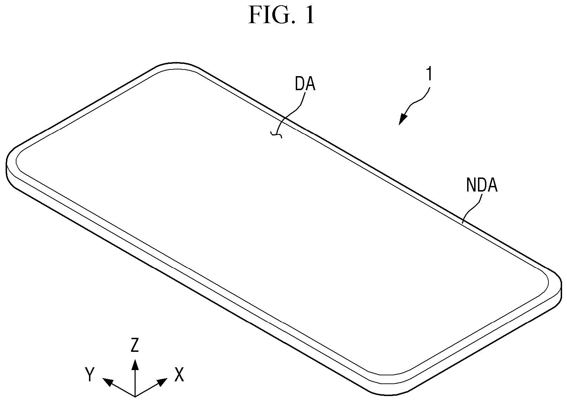

FIG. 1 is a perspective view illustrating an electronic device according to an embodiment.

Referring to FIG. 1, an embodiment of an electronic device 1 displays a moving image or a still image. The electronic device 1 may be referred to as all electronic devices that provide a display screen. For example, a television, a laptop computer, a monitor, an advertising board, Internet of Things, a mobile phone, a smart phone, a tablet personal computer (PC), an electronic watch, smart glasses, a smart watch, a watch phone, a head mounted display, a mobile communication terminal, an electronic diary, an electronic book, a portable multimedia player (PMP), a navigator, a game machine, a digital camera, a camcorder and the like, which provide a display screen, may be included in the electronic device 1.

In FIG. 1, a first direction (X-axis direction), a second direction (Y-axis direction) and a third direction (Z-axis direction) are defined. The first direction (X-axis direction) and the second direction (Y-axis direction) may be perpendicular to each other, the first direction (X-axis direction) and the third direction (Z-axis direction) may be perpendicular to each other, and the second direction (Y-axis direction) and the third direction (Z-axis direction) may be perpendicular to each other. The first direction (X-axis direction) refers to a horizontal direction in the drawing, the second direction (Y-axis direction) refers to a vertical direction in the drawing, and the third direction (Z-axis direction) refers to an upper and lower direction in the drawing, that is, a thickness direction. In the following specification, unless otherwise specified, the "direction" may refer to both directions extended along the direction. In addition, when it is desired to distinguish both "directions" extended to both sides, one side will be referred to as "one side direction" and the other side will be referred to as "other side direction", respectively. Based on FIG. 1, a direction toward which an arrow indicating a direction is directed will be referred to as one side in the direction, and an opposite direction thereof will be referred to as the other side in the direction.

Hereinafter, for convenience of description, when referring to the electronic device 1 or surfaces of each member constituting the electronic device 1, a direction in which an image is displayed, that is, one surface directed toward one side in the third direction (Z-axis direction) will be referred to as an upper surface, and its opposite surface will be referred to as the other surface, but the disclosure is not limited thereto. The one surface and the other surface of the member may be referred to as a front surface and a rear surface, respectively, or may be referred to as a first surface or a second surface. In addition, in describing a relative position of each member of the electronic device 1, one side in the third direction (Z-axis direction) may be referred to as an upper portion, and the other side in the third direction (Z-axis direction) may be referred to as a lower portion.

Various modifications may be made in a shape of the electronic device 1. For example, the electronic device 1 may have a shape such as a rectangle of a long width, a rectangle of a long length, a square, a rectangle of round corners (vertexes), other polygons or a circle.

The electronic device 1 may include a display area DA and a non-display area NDA. The display area DA is an area in which a screen may be displayed, and the non-display area NDA is an area in which a screen is not displayed. The display area DA may be referred to as an active area, and the non-display area NDA may be referred to as a non-active area. The display area DA may generally occupy the center of the electronic device 1.

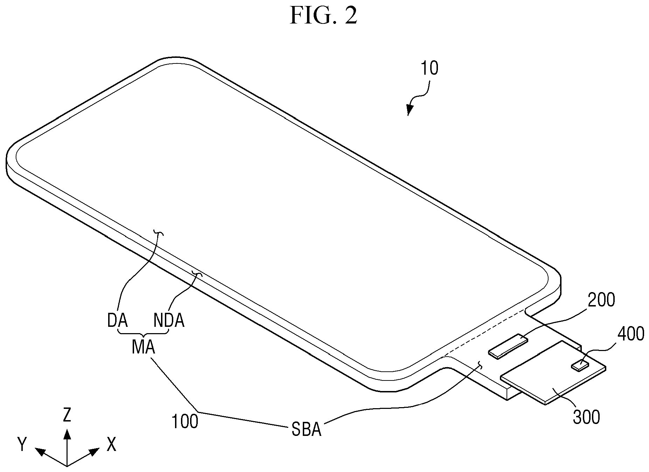

FIG. 2 is a perspective view illustrating a display device 10 included in the electronic device 1 according to an embodiment.

Referring to FIG. 2, the electronic device 1 according to an embodiment may include a display device 10. The display device 10 may provide a screen of the electronic device 1. Examples of the display device 10 may include an inorganic light emitting diode display device, an organic light emitting display device, a quantum dot light emitting display device, a plasma display device, and a field emission display device. The following description will be based on that the display device 10 is an organic light emitting diode display device, but the disclosure is not limited thereto, and the display device 10 is applicable to another display device within the range that the same technical ideas are applicable thereto.

The display device 10 may have a planar shape similar to that of the electronic device 1. For example, the display device 10 may have a planar shape similar to a rectangular shape having a short side in the first direction (X-axis direction) and a long side in the second direction (Y-axis direction). A corner at which the short side in the first direction (X-axis direction) meets the long side in the second direction (Y-axis direction) may be rounded to have a predetermined curvature, but may be formed at a right angle without being limited thereto. The planar shape of the display device 10 may have another polygonal shape or a shape similar to a circular shape or an oval shape without being limited to the rectangular shape.

An embodiment of the display device 10 may include a display panel 100, a display driver 200, a circuit board 300, and a touch driver 400.

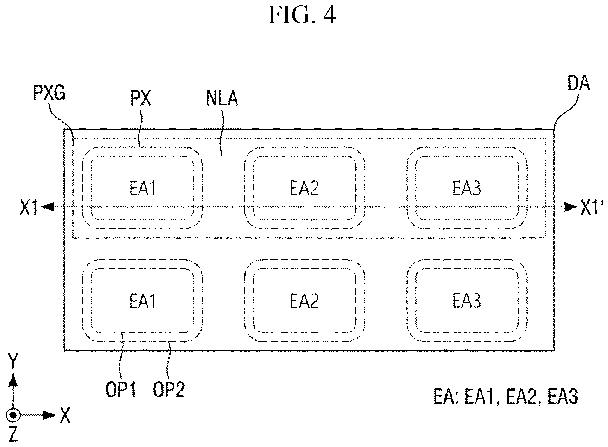

The display panel 100 may include a main area MA and a sub-area SBA. The main area MA may include a display area DA including pixels ('PX' of FIG. 4) for displaying an image, and a non-display area NDA disposed near the display area DA.

The display area DA may emit light from a plurality of light emission areas or a plurality of openings defined therein. The non-display area NDA may be an outer area of the display area DA. The non-display area NDA may be defined as an edge area of the main area MA of the display panel 100.

In an embodiment, the sub-area SBA may extend from one side of the main area MA. The sub-area SBA may include a flexible material capable of being subjected to bending, folding, rolling or the like. For example, in a state where the sub-area SBA is bent, the sub-area SBA may overlap the main area MA in a thickness direction (e.g., the third direction (Z-axis direction)). In another embodiment, the sub-area SBA may be omitted, and the display driver 200 and a pad portion may be disposed in the non-display area NDA.

The display driver 200 may output signals and voltages for driving the display panel 100. The display driver 200 may be formed of (or defined by) an integrated circuit (IC), and may be packaged on the display panel 100 by a chip on glass (COG) method, a chip on plastic (COP) method or an ultrasonic bonding method. In an embodiment, for example, the display driver 200 may be disposed in the sub-area SBA, and may overlap the main area MA in the thickness direction by bending of the sub-area SBA. In another embodiment, for example, the display driver 200 may be packaged on the circuit board 300.

The circuit board 300 may be attached onto the pad portion of the display panel 100 by using an anisotropic conductive film (ACF). The circuit board 300 may be a flexible printed circuit board, a printed circuit board, or a flexible film such as a chip on film.

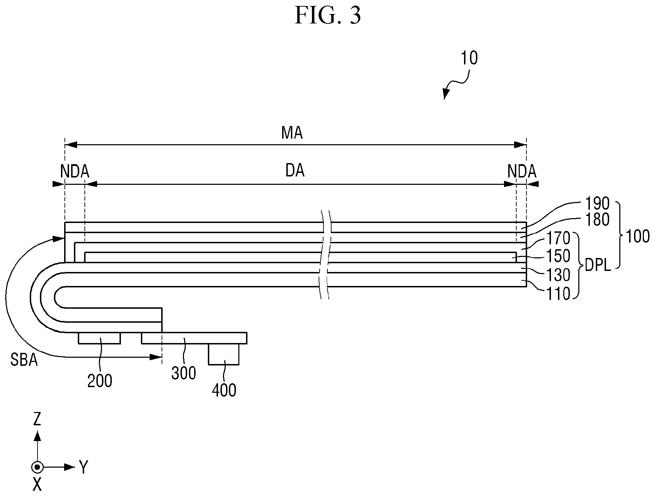

The touch driver 400 may be packaged on the circuit board 300. The touch driver 400 may be connected to a touch sensor layer (` 180' of FIG. 3) of the display panel 100. The touch driver 400 may be formed of an IC.

FIG. 3 is a schematic cross-sectional view illustrating the display device 10 of FIG. 2.

Referring to FIG. 3, an embodiment of the display panel 100 may include a display layer DPL, a touch sensor layer 180, and a color filter layer 190. The display layer DPL may include a substrate 110, a thin film transistor layer 130, a display element layer 150, and a thin film encapsulation layer 170.

The substrate 110 may be a base substrate or a base member. The substrate 110 may be a flexible substrate capable of being subjected to bending, folding, rolling or the like. In an embodiment, for example, the substrate 110 may include a polymer resin such as polyimide (PI), but is not limited thereto. In another embodiment, the substrate 110 may include a glass material or a metal material.

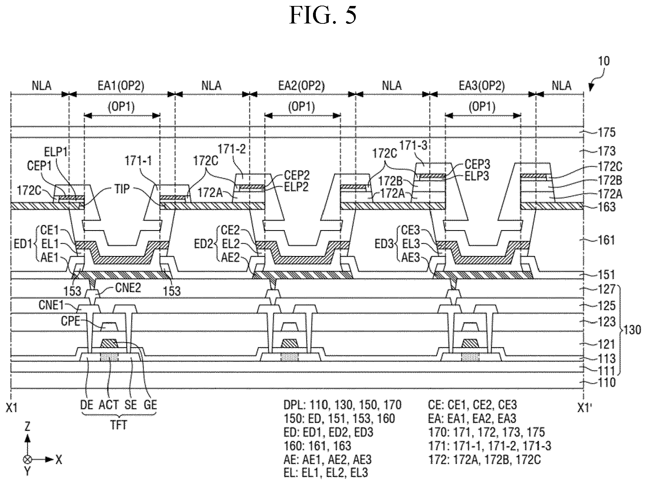

The thin film transistor layer 130 may be disposed on the substrate 110. The thin film transistor layer 130 may be disposed in the display area DA, the non-display area NDA, and the sub-area SBA. The thin film transistor layer 130 may include a plurality of thin film transistors ('TFT' of FIG. 5) constituting the pixels ('PX' of FIG. 4).

The display element layer 150 may be disposed on the thin film transistor layer 130. The display element layer 150 may be positioned to overlap the display area DA. The display element layer 150 may include a plurality of light emitting elements ('ED' of FIG. 5). For example, the display element according to an embodiment may include at least one of an organic light emitting diode including an organic light emitting layer, a quantum dot light emitting diode (LED) including a quantum dot light emitting layer, an inorganic light emitting diode including an inorganic semiconductor, or a micro light emitting diode (Micro LED), but is not limited thereto.

The thin film encapsulation layer 170 may be positioned on the display element layer 150. The thin film encapsulation layer 170 may be positioned to overlap the display area DA and the non-display area NDA. The thin film encapsulation layer 170 may cover an upper surface and sides of the display element layer 150, and may protect the display element layer 150 from external oxygen and moisture. The thin film encapsulation layer 170 may include at least one inorganic layer and at least one organic layer for encapsulating the display element layer 150.

The touch sensor layer 180 may be disposed on the thin film encapsulation layer 170. The touch sensor layer 180 may be positioned to overlap the display area DA and the non-display area NDA. The touch sensor layer 180 may sense a user's touch in a mutual capacitance manner or a self-capacitance manner.

The color filter layer 190 may be disposed on the touch sensor layer 180. The color filter layer 190 may be positioned to overlap the display area DA and the non-display area NDA. The color filter layer 190 may reduce reflective light due to external light by absorbing a portion of light introduced from the outside of the display device 10. Therefore, the color filter layer 190 may prevent color distortion due to reflection of external light from occurring.

In an embodiment where the color filter layer 190 is directly disposed on the touch sensor layer 180, the display device 10 may not include a separate substrate for the color filter layer 190. Therefore, a thickness of the display device 10 may be relatively small. In another embodiment, the color filter layer 190 may be omitted.

In an embodiment, as shown in FIG. 3, a portion of the display layer DPL overlapping the sub-area SBA may be bent. In a state where a portion of the display layer DPL is bent, the display driver 200, the circuit board 300 and the touch driver 400 may overlap the main area MA in the third direction (Z-axis direction).

FIG. 4 is a plan view illustrating arrangement of the light emission area EA in the display area DA of FIG. 3.

Referring to FIG. 4, the display area DA according to an embodiment may include a plurality of first to third light emission areas EA1, EA2 and EA3 and a non-light emission area NLA. The non-light emission area NLA may be positioned to surround the plurality of first to third light emission areas EA1, EA2 and EA3.

The non-light emission area NLA may shield light emitted from each of the plurality of first to third light emission areas EA1, EA2 and EA3. In such an embodiment, the non-light emission area NLA may allow light emitted from the plurality of first to third light emission areas EA1, EA2 and EA3 not to be mixed with each other. A pixel defining layer ('151' of FIG. 5) and a bank structure ('160' of FIG. 5), which will be described later, may be disposed in the non-light emission area NLA.

The light emission area EA may include a first light emission area EA1, a second light emission area EA2 and a third light emission area EA3, which emit light of different colors, respectively. Each of the first to third light emission areas EA1, EA2 and EA3 may emit red, green or blue light, and the color of light emitted from each of the first to third light emission areas EA1, EA2 and EA3 may be different depending on a type of a light emitting element ED that will be described later. In an embodiment, for example, the first light emission area EA1 may emit red light of a first color, the second light emission area EA2 may emit green light of a second color and the third light emission area EA3 may emit blue light of a third color, but the disclosure is not limited thereto. Although an embodiment where the first to third light emission areas EA1, EA2 and EA3 have the same size and shape is shown in FIG. 3, the disclosure is not limited thereto. The size and shape of each of the first to third light emission areas EA1, EA2 and EA3 may be freely adjusted depending on desired characteristics.

The plurality of first to third light emission areas EA1, EA2 and EA3 may be defined by a first opening OP1 and a second opening OP2. In an embodiment, for example, the first opening OP1 may be defined by the pixel defining layer ('151' of FIG. 5) that will be described later, and the second opening OP2 may be defined by the bank structure ('160' of FIG. 5) that will be described later. The second opening OP2 may completely surround the first opening OP1 on a plane, and the second opening OP2 may be completely surrounded by the non-light emission area NLA on a plane.

In some embodiments, at least one first light emission area EA1, at least one second light emission area EA2 and at least one third light emission area EA3, which are disposed to be adjacent to one another, may constitute one pixel group PXG. The pixel group PXG may be a minimum unit for emitting white light. However, various modifications may be made in the type and/or number of the first to third light emission areas EA1, EA2 and EA3 constituting the pixel group PXG depending on the embodiments.

FIG. 5 is a schematic cross-sectional view illustrating a display layer DPL taken along line X1-X1' of FIG. 4. FIG. 5 illustrates a schematic cross-section of a display layer DPL that overlaps the display area DA. That is, FIG. 5 illustrates a cross-section of a substrate 110, a thin film transistor layer 130, a display element layer 150 and a thin film encapsulation layer 170 of the display device 10 according to an embodiment. Since the substrate 110 is substantially the same as that described above, any repetitive detailed description thereof will be omitted.

Referring to FIG. 5, the thin film transistor layer 130 may be positioned on the substrate 110. The thin film transistor layer 130 may include a first buffer layer 111, a thin film transistor TFT, a gate insulating layer 113, a first interlayer insulating layer 121, a capacitor electrode CPE, a second interlayer insulating layer 123, a first connection electrode CNE1, a first via layer 125, a second connection electrode CNE2, and a second via layer 127.

The first buffer layer 111 may be disposed on the substrate 110. The first buffer layer 111 may include an inorganic layer capable of preventing permeation of the air or moisture. In an embodiment, for example, the first buffer layer 111 may include a plurality of inorganic layers that are alternately stacked.

The thin film transistor TFT may be disposed on the first buffer layer 111, and may constitute a pixel circuit connected to each of the pixels. In an embodiment, for example, the thin film transistor TFT may be a driving transistor or a switching transistor of the pixel circuit. The thin film transistor TFT may include an active layer ACT, a source electrode SE, a drain electrode DE, and a gate electrode GE.

The active layer ACT may be disposed on the first buffer layer 111. The active layer ACT may overlap the gate electrode GE in the third direction (Z-axis direction), and may be insulated from the gate electrode GE by the gate insulating layer 113. A portion of the active layer ACT may be conductorized to form the source electrode SE and the drain electrode DE.

The gate electrode GE may be disposed on the gate insulating layer 113. The gate electrode GE may overlap the active layer ACT with the gate insulating layer 113 interposed therebetween.

The gate insulating layer 113 may be disposed on the active layer ACT. The gate insulating layer 113 may cover the active layer ACT and the first buffer layer 111, and may insulate the active layer ACT from the gate electrode GE. The gate insulating layer 113 may be provided with a contact hole through which the first connection electrode CNE1 passes.

The first interlayer insulating layer 121 may cover the gate electrode GE and the gate insulating layer 113. The first interlayer insulating layer 121 may be provided with a contact hole through which the first connection electrode CNE1 passes. The contact hole of the first interlayer insulating layer 121 may be connected to a contact hole of the gate insulating layer 113 and a contact hole of the second interlayer insulating layer 123.

The capacitor electrode CPE may be disposed on the first interlayer insulating layer 121. The capacitor electrode CPE may overlap the gate electrode GE in the third direction (Z-axis direction). The capacitor electrode CPE and the gate electrode GE may form a capacitance.

The second interlayer insulating layer 123 may cover the capacitor electrode CPE and the first interlayer insulating layer 121. The second interlayer insulating layer 123 may be provided with a contact hole through which the first connection electrode CNE1 passes. The contact hole of the second interlayer insulating layer 123 may be connected to the contact hole of the first interlayer insulating layer 121 and the contact hole of the gate insulating layer 113.

The first connection electrode CNE1 may be disposed on the second interlayer insulating layer 123. The first connection electrode CNE1 may electrically connect the drain electrode DE of the thin film transistor TFT to the second connection electrode CNE2. The first connection electrode CNE1 may be inserted into the contact holes formed in the first interlayer insulating layer 121, the second interlayer insulating layer 123 and the gate insulating layer 113, and thus may be in contact with the drain electrode DE of the thin film transistor TFT.

The first via layer 125 may cover the first connection electrode CNE1 and the second interlayer insulating layer 123. The first via layer 125 may planarize a lower structure. The first via layer 125 may be provided with a contact hole through which the second connection electrode CNE2 passes.

The second connection electrode CNE2 may be disposed on the first via layer 125. The second connection electrode CNE2 may be inserted into the contact hole formed in the first via layer 125 to contact the first connection electrode CNE1. The second connection electrode CNE2 may electrically connect the first connection electrode CNE1 to an anode electrode AE.

The second via layer 127 may cover the second connection electrode CNE2 and the first via layer 125. The second via layer 127 may be provided with a contact hole through which the anode electrode AE passes.

The display element layer 150 may be disposed on the second via layer 127. The display element layer 150 may include a light emitting element ED, a pixel defining layer 151, a residual pattern 153, and a bank structure 160.

The light emitting element ED may include an anode electrode AE, a light emitting layer EL, and a cathode electrode CE. The light emitting element ED may include a first light emitting element ED1 disposed in the first light emission area EA1, a second light emitting element ED2 disposed in the second light emission area EA2, and a third light emitting element ED3 disposed in the third light emission area EA3.

The light emitting element ED that overlaps each of the light emission areas EA1, EA2 and EA3 may emit light of different colors depending on the material of the light emitting layer EL. In an embodiment, for example, the first light emitting element ED1 may emit red light of a first color, the second light emitting element ED2 may emit green light of a second color, and the third light emitting element ED3 may emit blue light of a third color.

The anode electrode AE may be disposed on the second via layer 127. The anode electrode AE may be electrically connected to the drain electrode DE of the thin film transistor TFT through the first connection electrode CNE1 and the second connection electrode CNE2.

The anode electrode AE may include a first anode electrode AE1 disposed in the first light emission area EA1, a second anode electrode AE2 disposed in the second light emission area EA2, and a third anode electrode AE3 disposed in the third light emission area EA3. The first anode electrode AE1, the second anode electrode AE2 and the third anode electrode AE3 may be disposed to be spaced apart from one another on the second via layer 127.

In an embodiment, the anode electrode AE may have a stacked layer structure in which a material layer, which has a high work function, such as indium-tin-oxide (ITO), indium-zinc-oxide (IZO), zinc oxide (ZnO) and indium oxide (In₂O₃), and a reflective material layer such as Ag, Mg, Al, Pt, Pb, Pd, Au, Ni, Nd, Ir, Cr, Li, Ca or their mixture are stacked. In an embodiment, for example, the anode electrode AE may have a multi-layered structure of ITO/Mg, ITO/MgF, ITO/Ag, and ITO/Ag/ITO, but is not limited thereto.

The pixel defining layer 151 may be positioned on the second via layer 127 and the anode electrode AE. The pixel defining layer 151 may separate and insulate the first to third anode electrodes AE1, AE2 and AE3 from one another. The pixel defining layer 151 according to an embodiment may define the first opening OP1. The pixel defining layer 151 may be entirely disposed on the second via layer 127 to expose a portion of an upper surface of the anode electrode AE. In other words, the pixel defining layer 151 may expose the anode electrode AE at a portion overlapping the first opening OP1, and the light emitting layer EL may be directly disposed on the anode electrode AE at a portion overlapping the first opening OP1.

The pixel defining layer 151 may include an inorganic insulating material. In an embodiment, for example, the pixel defining layer 151 may include at least one selected from silicon oxide, silicon nitride, and silicon oxynitride.

The bank structure 160 may be positioned on the pixel defining layer 151. The bank structure 160 may be disposed at a portion overlapping the non-light emission area NLA. The bank structure 160 according to an embodiment may include a first bank layer 161 and a second bank layer 163, which are disposed on the pixel defining layer 151. The bank structure 160 may have a structure in which the first bank layer 161 and the second bank layer 163 are sequentially stacked in the third direction (Z-axis direction). The first bank layer 161 and the second bank layer 163 may include conductive materials different from each other, respectively. The bank structure 160 according to an embodiment may define the second opening OP2.

The bank structure 160 may include a tip TIP protruded toward the light emission area EA. In the display device 10 according to an embodiment, as the bank structure 160 includes the tip TIP, the first to third light emitting elements ED1, ED2 and ED3 disposed to respectively overlap the first to third light emission areas EA1, EA2 and EA3 may be formed without a fine metal mask during a fabricating process of the display device 10. As a result, the display device 10 according to an embodiment may form a plurality of light emitting elements ED applicable to the display device of high resolution by realizing high pixel integration.

The light emitting layer EL may be disposed on the anode electrode AE. The light emitting layer EL may be an organic light emitting layer made of an organic material, and may be formed on the anode electrode AE through a deposition process. When the thin film transistor TFT applies a predetermined voltage to the anode electrode AE and the cathode electrode CE receives a common voltage or a cathode voltage, holes and electrons may move to the light emitting layer EL through a hole transport layer and an electron transport layer, respectively, and may be combined with each other in the light emitting layer EL to emit light.

The light emitting layer EL may include a first light emitting layer EL1, a second light emitting layer EL2 and a third light emitting layer EL3, which are respectively disposed in the first to third light emission areas EA1, EA2 and EA3. In an embodiment, for example, the first light emitting layer EL1 may be a light emitting layer for emitting red light of a first color, the second light emitting layer EL2 may be a light emitting layer for emitting green light of a second color, and the third light emitting layer EL3 may be a light emitting layer for emitting blue light of a third color, but the disclosure is not limited thereto.

In some embodiments, the anode electrode AE and the pixel defining layer 151 may be spaced apart from each other in the third direction (Z-axis direction). The residual pattern 153 may be positioned at a portion where the anode electrode AE and the pixel defining layer 151 are spaced apart from each other. The residual pattern 153 will be described later in greater detail.

The cathode electrode CE may be disposed on the light emitting layer EL. The cathode electrode CE may include a transparent conductive material so that light generated from the light emitting layer EL may be emitted. The cathode electrode CE may receive a common voltage or a low potential voltage. When the anode electrode AE receives a voltage corresponding to a data voltage and the cathode electrode CE receives a low potential voltage, a potential difference is formed between the anode electrode AE and the cathode electrode CE, so that the light emitting layer EL may emit light.

In an embodiment, the cathode electrode CE may include a material layer having a small work function, such as Li, Ca, LiF/Ca, LiF/Al, Al, Mg, Ag, Pt, Pd, Ni, Au Nd, Ir, Cr, BaF, Ba or a combination (compound or mixture) thereof (e.g., a mixture of Ag and Mg). The cathode electrode CE may further include a transparent metal oxide layer disposed on the material layer having a small work function.

The cathode electrode CE may include a first cathode electrode CE1, a second cathode electrode CE2 and a third cathode electrode CE3, which are respectively disposed in the first to third light emission areas EA1, EA2 and EA3. The first cathode electrode CE1 may be disposed on the first light emitting layer EL1 in the first light emission area EA1, the second cathode electrode CE2 may be disposed on the second light emitting layer EL2 in the second light emission area EA2, and the third cathode electrode CE3 may be disposed on the third light emitting layer EL3 in the third light emission area EA3.

The cathode electrode CE included in an embodiment may be spaced apart from another cathode electrode at a portion that overlaps each of the first to third light emission areas EA1, EA2 and EA3. The cathode electrode CE included in an embodiment may not be directly connected to another common electrode, but may be electrically connected to another common electrode through the first bank layer 161.

A plurality of first to third organic patterns ELP1, ELP2 and ELP3 and first to third electrode patterns CEP1, CEP2 and CEP3 may be positioned on the bank structure 160. The plurality of first to third organic patterns ELP1, ELP2 and ELP3 and the first to third electrode patterns CEP1, CEP2 and CEP3 may be disposed to surround the periphery of the first opening OP1.

Each of the first to third organic patterns ELP1, ELP2, and ELP3 may include a same material as that of the first to third light emitting layers EL1, EL2, and EL3. In detail, the first organic pattern ELP1 may include a same material as that of the first light emitting layer EL1, the second organic pattern ELP2 may include a same material as that of the second light emitting layer EL2, and the third organic pattern ELP3 may include a same material as that of the third light emitting layer EL3. The first to third organic patterns ELP1, ELP2 and ELP3 may be marks formed by being disconnected from the first to third light emitting layers EL1, EL2, and EL3 as the bank structure 160 includes the tip TIP.

The first to third electrode patterns CEP1, CEP2 and CEP3 may be disposed on the first to third organic patterns ELP1, ELP2 and ELP3, respectively. In an embodiment, for example, the first electrode pattern CEP1, the second electrode pattern CEP2 and the third electrode pattern CEP3 may be directly disposed on the first organic pattern ELP1, the second organic pattern ELP2 and the third organic pattern ELP3, respectively. An arrangement relation of the first to third electrode patterns CEP1, CEP2 and CEP3 and the first to third organic patterns ELP1, EL2, and ELP3 may be the same as an arrangement relation of the first to third light emitting layers EL1, EL2 and EL3 and the first to third cathode electrodes CE1, CE2 and CE3. Each of the first to third electrode patterns CEP1, CEP2 and CEP3 may include the same material as that of the first to third cathode electrodes CE1, CE2 and CE3. The first to third electrode patterns CEP1, CEP2 and CEP3 may be marks formed by being disconnected from the first to third cathode electrodes CE1, CE2 and CE3 as the bank structure 160 includes the tip TIP.

The thin film encapsulation layer 170 may be disposed on the first to third cathode electrodes CE1, CE2 and CE3 and the first to third electrode patterns CEP1, CEP2 and CEP3. The thin film encapsulation layer 170 may be in contact with the first to third cathode electrodes CE1, CE2 and CE3 and the first to third electrode patterns CEP1, CEP2 and CEP3.

The thin film encapsulation layer 170 may include a first encapsulation layer 171, an element passivation layer 172, a second encapsulation layer 173, and a third encapsulation layer 175. The first encapsulation layer 171, the element passivation layer 172 and the third encapsulation layer 175 may be an inorganic encapsulation layer, and the second encapsulation layer 173 may be an organic encapsulation layer.

The first encapsulation layer 171 according to an embodiment may be in contact with the first to third cathode electrodes CE1, CE2 and CE3 and the first to third electrode patterns CEP1, CEP2 and CEP3. The first encapsulation layer 171 may cover the cathode electrodes and the electrode patterns along a profile of the lower structure. Therefore, the first encapsulation layer 171 may have a step difference. The first encapsulation layer 171 may protect the plurality of light emitting elements ED so that moisture and oxygen may be prevented from being permeated into the plurality of light emitting elements ED.

The first encapsulation layer 171 according to an embodiment may include a first inorganic layer 171-1, a second inorganic layer 171-2, and a third inorganic layer 171-3. The first inorganic layer 171-1, the second inorganic layer 171-2 and the third inorganic layer 171-3 may be positioned at portions respectively overlapping the first light emission area EA1, the second light emission area EA2 and the third light emission area EA3. In an embodiment, for example, the first inorganic layer 171-1 may cover the first light emitting element ED1 and the first electrode pattern CEP1, the second inorganic layer 171-2 may cover the second light emitting element ED2 and the second electrode pattern CEP2, and the third inorganic layer 171-3 may cover the third light emitting element ED3 and the third electrode pattern CEP3. The first inorganic layer 171-1, the second inorganic layer 171-2 and the third inorganic layer 171-3 may be spaced apart from one another in the first direction (X-axis direction) at portions overlapping the non-light emission area NLA.

The first inorganic layer 171-1, the second inorganic layer 171-2 and the third inorganic layer 171-3 according to an embodiment may be formed by their respective processes different from one another. In an embodiment, for example, the first inorganic layer 171-1 may be formed after the first cathode electrode CE1 is formed, the second inorganic layer 171-2 may be formed after the second cathode electrode CE2 is formed, and the third inorganic layer 171-3 may be formed after the third cathode electrode CE3 is formed. The fabricating process will be described later in greater detail.

The first encapsulation layer 171 may include one or more inorganic insulating materials. The inorganic insulating material may include at least one selected from aluminium oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), and silicon oxynitride (Si₂N₂O).

The element passivation layer 172 may be disposed on the second bank layer 163. The element passivation layer 172 may cover the first to third organic patterns ELP1, ELP2 and ELP3 and the first to third electrode patterns CEP1, CEP2 and CEP3 during the fabricating process of the display device 10, thereby resolving moisture permeation defects caused by moisture and oxygen or an etching solution.

The element passivation layer 172 may include a silicon-based inorganic insulating material. In an embodiment, for example, the element passivation layer 172 may include at least one selected from silicon oxide (SiO₂), silicon nitride (Si₃N₄), and silicon oxynitride (Si₂N₂O).

The element passivation layer 172 according to an embodiment may include a first passivation layer 172A, a second passivation layer 172B, and a third passivation layer 172C.

The first passivation layer 172A according to an embodiment may be disposed at a portion overlapping the non-light emission area NLA adjacent to the second light emission area EA2 and near the second light emission area EA2 and a portion overlapping the non-light emission area NLA adjacent to the third light emission area EA3 and near the third light emission area EA3. The first passivation layer 172A may be disposed in contact with the second bank layer 163. The first passivation layer 172A according to an embodiment may not overlap the first light emission area EA1.

The second passivation layer 172B according to an embodiment may be disposed at a portion overlapping the non-light emission area NLA adjacent to the third light emission area EA3 and near the third light emission area EA3. The second passivation layer 172B may be disposed in contact with the first passivation layer 172A. The second passivation layer 172B according to an embodiment may not overlap the first light emission area EA1 and the second light emission area EA2.

The third passivation layer 172C according to an embodiment may be disposed at a portion overlapping the non-light emission area NLA, and may not overlap the first to third light emission areas EA1, EA2 and EA3. The third passivation layer 172C may be in contact with the first to third organic patterns ELP1, ELP2 and ELP3 and the first to third electrode patterns CEP1, CEP2 and CEP3.

The first passivation layer 172A, the second passivation layer 172B and the third passivation layer 172C according to an embodiment may be formed by their respective processes different from one another. In an embodiment, for example, the first passivation layer 172A may be formed after the first inorganic layer 171-1 is formed, the second passivation layer 172B may be formed after the second inorganic layer 171-2 is formed, and the third passivation layer 172C may be formed after the third inorganic layer 171-3 is formed. The fabricating process will be described later in greater detail.

The second encapsulation layer 173 may be disposed on the first encapsulation layer 171. The second encapsulation layer 173 may planarize a step difference formed by the first encapsulation layer 171 and the element passivation layer 172. The second encapsulation layer 173 may be in contact with the first encapsulation layer 171, the element passivation layer 172 and the second bank layer 163.

The second encapsulation layer 173 may include a polymer-based material. The polymer-based material may include at least one selected from an acrylic resin, an epoxy resin, polyimide, polyethylene, etc. For example, the second encapsulation layer 173 may include an acrylic resin, for example, polymethyl methacrylate, polyacrylic acid, etc. The second encapsulation layer 173 may be formed by curing a monomer or coating a polymer.

The third encapsulation layer 175 according to an embodiment may be disposed in contact with the second encapsulation layer 173. The third encapsulation layer 175 may protect the display element layer 150 so that oxygen and moisture may not be permeated into the display element layer 150.

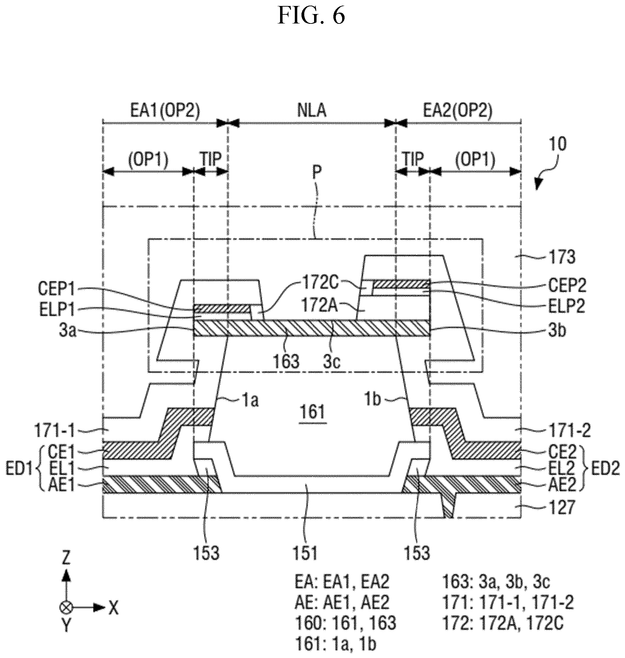

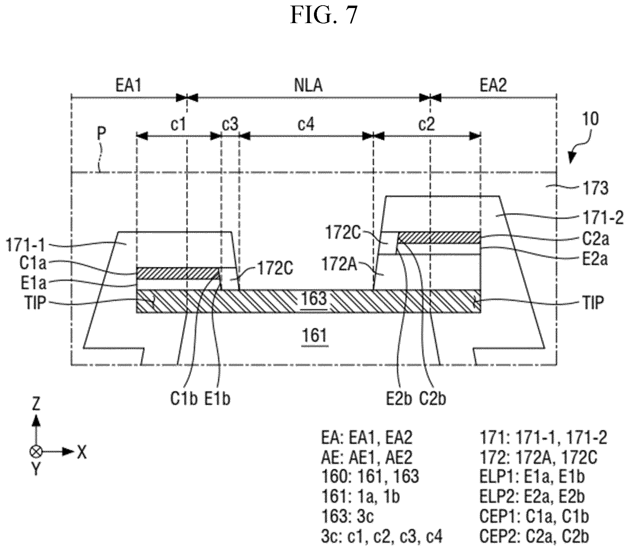

FIG. 6 is a schematic enlarged cross-sectional view illustrating a non-light emission area NLA disposed between a first light emission area EA1 and a second light emission area EA2 in FIG. 5. FIG. 7 is an enlarged cross-sectional view illustrating an area 'P' in FIG. 6.

Referring to FIG. 6, the first light emission area EA1 and the second light emission area EA2 according to an embodiment may be spaced apart from each other with the non-light emission area NLA interposed therebetween. As described above, the first opening OP1 according to an embodiment may be defined by the pixel defining layer 151, and the second opening OP2 may be defined by the first bank layer 161.

The first bank layer 161 according to an embodiment may be disposed in contact with the pixel defining layer 151. The first bank layer 161 according to an embodiment may include a material having high electrical conductivity, and thus may electrically connect the first and second cathode electrodes CE1 and CE2, which are spaced apart from each of the first and second light emission areas EA1 and EA2, to each other. In an embodiment, for example, the first bank layer 161 may include aluminium (Al) or copper (Cu).

In some embodiments, the first bank layer 161 may include a first side 1a directed toward (or facing) the first light emission area EA1 and a second side 1b directed toward the second light emission area EA2. The first side 1a of the first bank layer 161 may be recessed in a direction toward a center of the first bank layer 161 or one side of the pixel defining layer 151 in the first direction (X-axis direction), and the second side 1b may be recessed in a direction toward a center of the first bank layer 161 or the other side of the pixel defining layer 151 in the first direction (X-axis direction). This may be caused because the first bank layer 161 according to an embodiment includes a material having a relatively higher etching rate than that of the pixel defining layer 151.

The first light emitting layer EL1, the first cathode electrode CE1 and the first inorganic layer 171-1 may be in contact with the first side 1a according to an embodiment, and the second light emitting layer EL2, the second cathode electrode CE2 and the second inorganic layer 171-2 may be in contact with the second side 1b.

The second bank layer 163 according to an embodiment may be disposed in contact with the first bank layer 161. The second bank layer 163 according to an embodiment may include a metal material having high electrical stability and a high adhesive force to a metal. In an embodiment, for example, the second bank layer 163 may include at least one selected from molybdenum (Mo), chromium (Cr), gold (Au), titanium (Ti), nickel (Ni) and neodymium (Nd), or an alloy thereof. The electrical conductivity of the first bank layer 161 may be higher than the electrical conductivity of the second bank layer 163. In one or more embodiments, the first bank layer 161 may include aluminium, and the second bank layer 163 may include titanium.

In some embodiments, the second bank layer 163 may include a first side 3a directed toward the first light emission area EA1, a second side 3b directed toward the second light emission area EA2, and an upper surface 3c connecting the first side 3a with the second side 3b. The first side 3a of the second bank layer 163 may be more protruded toward the first light emission area EA1 than the first side 1a of the first bank layer 161, and the second side 3b of the second bank layer 163 may be more protruded toward the second light emission area EA2 than the second side 1b of the first bank layer 161. The upper surface 3c will be described later in greater detail.

The display device 10 according to an embodiment may include a metal material in which the second bank layer 163 is relatively stable in an etching process as compared with the first bank layer 161 during the fabricating process. In other words, an etching rate of the second bank layer 163 may be lower than that of the first bank layer 161. Accordingly, the first side 3a and the second side 3b of the second bank layer 163 may be more protruded toward the light emission area EA than the first bank layer 161. In other words, the second bank layer 163 may include a tip TIP more protruded to opposing sides toward the first light emission area EA1 and the second light emission area EA2 than the first bank layer 161, and an undercut may be formed between the first bank layer 161 and the tip TIP of the second bank layer 163.

In some embodiments, a height of the first bank layer 161 in the third direction (Z-axis direction) may be greater than that of the second bank layer 163.

The residual pattern 153 according to an embodiment may be disposed between the anode electrode AE and the pixel defining layer 151 in the third direction (Z-axis direction). The residual pattern 153 according to an embodiment may overlap the protruded tip TIP of the bank structure 160 in the third direction (Z-axis direction).

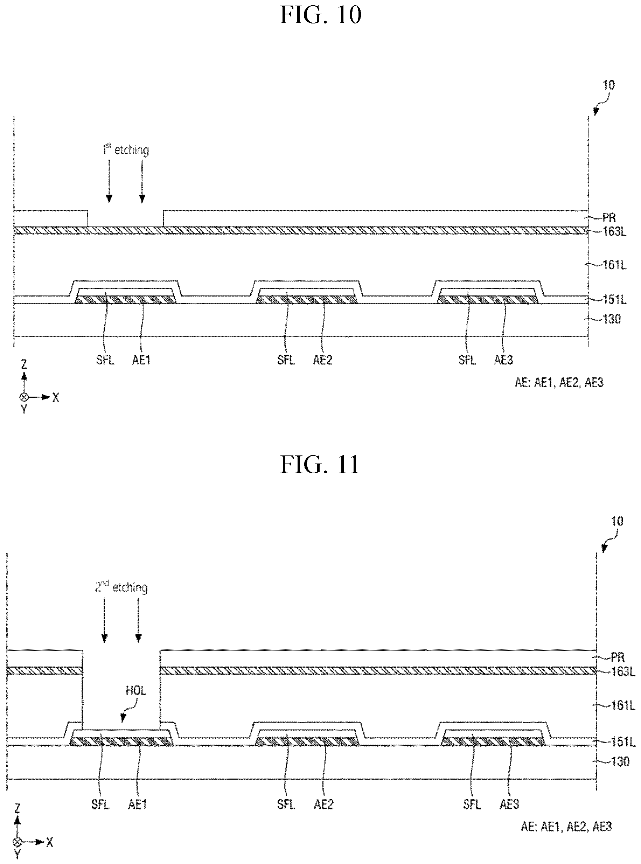

The display device 10 according to an embodiment may include a sacrificial layer ('SFL' of FIG. 10) between the pixel defining layer 151 and the anode electrode AE during the fabricating process. The sacrificial layer SFL may be disposed between the pixel defining layer 151 and the first anode electrode AE1 and between the pixel defining layer 151 and the second anode electrode AE2, and then may be partially removed by a subsequent wet etching process. In this case, the sacrificial layer SFL, which is not partially removed, may remain as the residual pattern 153 between the pixel defining layer 151 and the anode electrode AE.

A step coverage of a deposition process of forming the first cathode electrode CE1 and the second cathode electrode CE2 according to an embodiment may be greater than that of a deposition process of forming the first light emitting layer EL1 and the second light emitting layer EL2. Therefore, the first cathode electrode CE1 according to an embodiment may completely cover the first light emitting layer EL1, and the second cathode electrode CE2 may completely cover the second light emitting layer EL2. A detailed fabricating process thereof will be described later in greater detail.

The first inorganic layer 171-1 according to an embodiment may completely cover the first light emitting element ED1 at a portion overlapping the first opening OP1, and may completely cover the first side 1a of the first bank layer 161, the tip TIP of the second bank layer 163, and a portion of the first organic pattern ELP1 and the first electrode pattern CEP1 at a portion overlapping the non-light emission area NLA. In addition, the first inorganic layer 171-1 may cover a portion of the first electrode pattern CEP1 at a portion overlapping the non-light emission area NLA, and may be in contact with the first electrode pattern CEP1. In addition, the first inorganic layer 171-1 may be in contact with the third passivation layer 172C at a portion overlapping the non-light emission area NLA.

The second inorganic layer 171-2 according to an embodiment may completely cover the second light emitting element ED2 at a portion overlapping the first opening OP1, and may cover the second side 1b of the first bank layer 161, the tip TIP of the second bank layer 163, the first passivation layer 172A and a portion of the second organic pattern ELP2 and the second electrode pattern CEP2 at a portion overlapping the second opening OP2. In addition, the second inorganic layer 171-2 may cover a portion of the second electrode pattern CEP2 at a portion overlapping the non-light emission area NLA, and may be in contact with the second electrode pattern CEP2. In addition, the second inorganic layer 171-2 may be in contact with the third passivation layer 172C at a portion overlapping the non-light emission area NLA.

The first inorganic layer 171-1 and the second inorganic layer 171-2 according to an embodiment may be spaced apart from each other in the first direction (X-axis direction) with the second encapsulation layer 173 interposed therebetween at a portion overlapping the non-light emission area NLA.

Referring to FIG. 7, the upper surface 3c of the second bank layer 163 may be divided into a first portion c1, a second portion c2, a third portion c3 and a fourth portion c4 in accordance with a contact structure.

In detail, the first portion c1 may be in contact with the first organic pattern ELP1, and the first portion c1 may be a portion overlapping the first electrode pattern CEP1 and the first inorganic layer 171-1. In addition, the second portion c2 may be in contact with the first passivation layer 172A, and may be a portion overlapping the second organic pattern ELP2, the second electrode pattern CEP2, the third passivation layer 172C and the second inorganic layer 171-2. The first portion c1 and the second portion c2 may overlap the tip TIP of the second bank layer 163.

The third portion c3 may be in contact with the third passivation layer 172C of the element passivation layer 172, and may overlap the first inorganic layer 171-1. In addition, the fourth portion c4 may be in contact with the second encapsulation layer 173. In other words, the fourth portion c4 may not overlap the first organic pattern ELP1, the second organic pattern ELP2, the first electrode pattern CEP1, the second electrode pattern CEP2, the first inorganic layer 171-1, the second inorganic layer 171-2 and the third passivation layer 172C.

The first organic pattern ELP1 according to an embodiment may be disposed in contact with the second bank layer 163.

In some embodiments, the first organic pattern ELP1 may include a first side E1a and a second side E1b. The first side E1a may be disposed at a portion overlapping the first light emission area EA1, and may be in contact with the first inorganic layer 171-1. In addition, the second side E1b may be disposed at a portion overlapping the non-light emission area NLA, and may be in contact with the third passivation layer 172C.

The first electrode pattern CEP1 according to an embodiment may be disposed in contact with the first organic pattern ELP1.

In some embodiments, the first electrode pattern CEP1 may include a first side C1a and a second side C1b. The first side C1a may be disposed at a portion overlapping the first light emission area EA1, and may be in contact with the first inorganic layer 171-1. In addition, the second side C1b may be disposed at a portion overlapping the non-light emission area NLA, and may be in contact with the third passivation layer 172C.

The second side E1b of the first organic pattern ELP1 and the second side C1b of the first electrode pattern CEP1 according to an embodiment may be exposed by the etching process during the fabricating process of the display device 10. Therefore, in the display device 10 according to an embodiment, a path through which moisture and oxygen are permeated may be formed through the second side E1b of the first organic pattern ELP1 and the second side C1b of the first electrode pattern CEP1. However, the display device 10 according to an embodiment may include the element passivation layer 172 completely covering the second side E1b of the first organic pattern ELP1 and the second side C1b of the first electrode pattern CEP1 during the fabricating process, thereby removing the permeation path of moisture and oxygen, which is caused during the fabricating process of the display device 10. The fabricating process thereof will be described later in greater detail.

The second organic pattern ELP2 according to an embodiment may be spaced apart from the second bank layer 163 in the third direction (Z-axis direction). The first passivation layer 172A of the element passivation layer 172 may be disposed between the second organic pattern ELP2 and the second bank layer 163, which are spaced apart from each other. The first passivation layer 172A may not overlap the first organic pattern ELP1 and the first electrode pattern CEP 1.

The first passivation layer 172A according to an embodiment may be formed after the first inorganic layer 171-1 is formed during the fabricating process of the display device 10. The first passivation layer 172A may completely cover the first inorganic layer 171-1, the first organic pattern ELP1 and the first electrode pattern CEP1, and then may be formed in a form shown by the etching process. That is, the first passivation layer 172A according to an embodiment may cover the second side E1b of the first organic pattern ELP1 and the second side C1b of the first electrode pattern CEP1 during the fabricating process of the display device 10, and then may be formed as shown by being partially removed by the etching process. The fabricating process thereof will be described later in greater detail.

The second organic pattern ELP2 according to an embodiment may be disposed on the first passivation layer 172A.

In some embodiments, the second organic pattern ELP2 may include a first side E2a and a second side E2b. The first side E2a may be disposed at a portion overlapping the second light emission area EA2, and may be in contact with the second inorganic layer 171-2. In addition, the second side E2b may be disposed at a portion overlapping the non-light emission area NLA, and may be in contact with the third passivation layer 172C.

The second electrode pattern CEP2 according to an embodiment may be disposed in contact with the second organic pattern ELP2.

In some embodiments, the second electrode pattern CEP2 may include a first side C2a and a second side C2b. The first side C2a may be disposed at a portion overlapping the second light emission area EA2, and may be in contact with the second inorganic layer 171-2. In addition, the second side C2b may be disposed at a portion overlapping the non-light emission area NLA, and may be in contact with the third passivation layer 172C.

The second side E2b of the second organic pattern ELP2 and the second side C2b of the second electrode pattern CEP2 according to an embodiment may be exposed by the etching process during the fabricating process of the display device 10, and thus may become a permeation path of moisture and oxygen or an etching solution. However, the display device 10 according to an embodiment includes the element passivation layer 172 covering the second side E2b of the second organic pattern ELP2 and the second side C2b of the second electrode pattern CEP2, thereby resolving the defect caused by moisture and oxygen or an etching solution. The fabricating process thereof will be described later in greater detail.

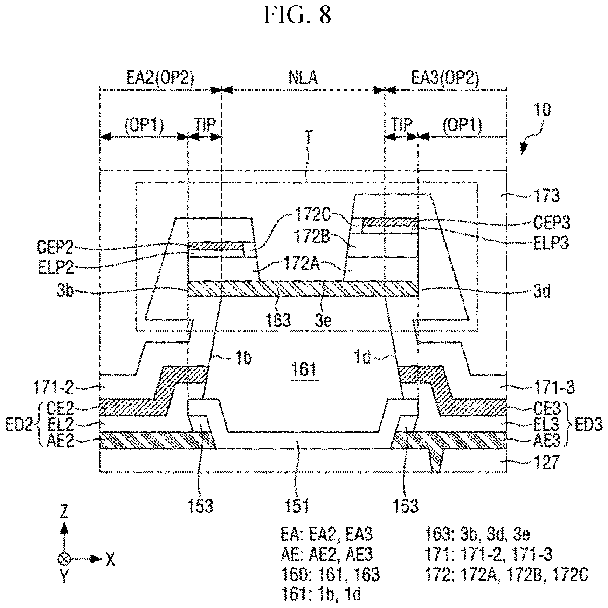

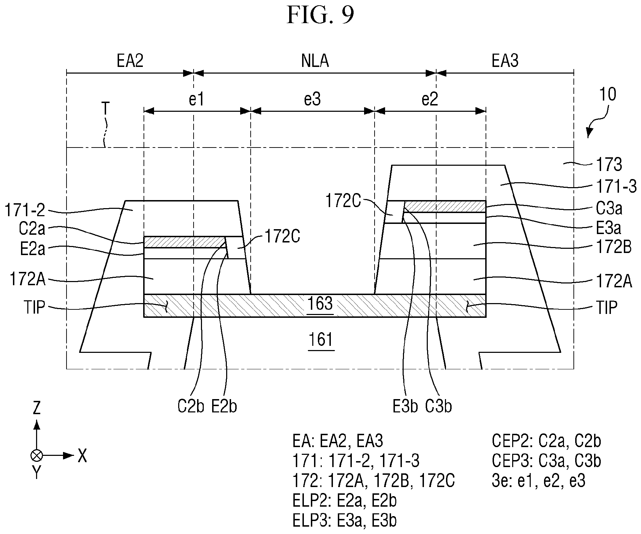

FIG. 8 is a schematic enlarged cross-sectional view illustrating a non-light emission area NLA disposed between a second light emission area EA2 and a third light emission area EA3 in FIG. 5. FIG. 9 is an enlarged cross-sectional view illustrating an area 'T' in FIG. 8.

Referring to FIG. 8, the second light emission area EA2 and the third light emission area EA3 according to an embodiment may be spaced apart from each other with the non-light emission area NLA interposed therebetween. As described above, the first opening OP1 according to an embodiment may be defined by the pixel defining layer 151, and the second opening OP2 may be defined by the first bank layer 161.

In some embodiments, the first bank layer 161 may include a second side 1b directed toward the second light emission area EA2 and a third side 1d directed toward the third light emission area EA3. In an embodiment, the third side 1d may be in contact with the third light emitting layer EL3, the third cathode electrode CE3 and the third inorganic layer 171-3.

In some embodiments, the second bank layer 163 may include a second side 3b directed toward the second light emission area EA2 and a third side 3d directed toward the third light emission area EA3, and an upper surface 3e connecting the second side 3b with the third side 3d.

The second side 3b of the second bank layer 163 may be more protruded toward the second light emission area EA2 than the second side 1b of the first bank layer 161, and the third side 3d of the second bank layer 163 may be more protruded toward the third light emission area EA3 than the third side 1d of the first bank layer 161. Therefore, the second bank layer 163 may have a tip TIP more protruded to opposing sides toward the second light emission area EA2 and the third light emission area EA3 than the first bank layer 161. The tip TIP of the second bank layer 163 is substantially the same as that described above, and any repetitive detailed description thereof will be omitted.

The second cathode electrode CE2 according to an embodiment may completely cover the second light emitting layer EL2, the third cathode electrode CE3 may completely cover the third light emitting layer EL3, and the second cathode electrode CE2 and the third cathode electrode CE3 may be electrically connected to each other by the first bank layer 161. Any repetitive detailed description of the same or like features thereof as those described above will be omitted.

The third inorganic layer 171-3 according to an embodiment may completely cover the third light emitting element ED3 at a portion overlapping the first opening OP1, and may cover the third side 1d of the first bank layer 161, the tip TIP of the second bank layer 163, the first passivation layer 172A, the second passivation layer 172B and a portion of the third organic pattern ELP3 and the third electrode pattern CEP3 at a portion overlapping the second opening OP2. In addition, the third inorganic layer 171-3 may cover a portion of the third electrode pattern CEP3 at a portion overlapping the non-light emission area NLA, and may be in contact with the third electrode pattern CEP3. In addition, the third inorganic layer 171-3 may be in contact with the third passivation layer 172C at a portion overlapping the non-light emission area NLA.

As described above, the second organic pattern ELP2 and the second electrode pattern CEP2 may be spaced apart from the second bank layer 163 in the third direction (Z-axis direction), and the first passivation layer 172A may be positioned therebetween. As the second organic pattern ELP2 and the second electrode pattern CEP2 do not overlap the second passivation layer 172B, the second organic pattern ELP2 and the second electrode pattern CEP2 are different from the third organic pattern ELP3 and the third electrode pattern CEP3.

Referring to FIG. 9, the upper surface 3e of the second bank layer 163 may be divided into a first portion e1, a second portion e2, and a third portion e3 in accordance with a contact structure.

In detail, the first portion e1 may be in contact with the first passivation layer 172A, and may be a portion overlapping the second organic pattern ELP2, the second electrode pattern CEP2, the third passivation layer 172C and the second inorganic layer 171-2. The first portion e1 may overlap the tip TIP of the second bank layer 163. In addition, the second portion e2 may be in contact with the first passivation layer 172A, and may be a portion overlapping the second passivation layer 172B, the third passivation layer 172C, the third organic pattern ELP3, the third electrode pattern CEP3 and the third inorganic layer 171-3. The second portion e2 may overlap the tip TIP of the second bank layer 163. The third portion e3 may be in contact with the second encapsulation layer 173. In other words, the second inorganic layer 171-2 and the third inorganic layer 171-3 may be spaced apart from each other in the first direction (X-axis direction) with a portion interposed therebetween, which overlaps the third portion e3.

A structure overlapping the second organic pattern ELP2 and the second electrode pattern CEP2 according to an embodiment is substantially the same as the structure of those described above, and any repetitive detailed description thereof will be omitted.

The third organic pattern ELP3 according to an embodiment may be spaced apart from the second bank layer 163 in the third direction (Z-axis direction). The first passivation layer 172A and the second passivation layer 172B, which are sequentially stacked in the third direction (Z-axis direction), may be disposed between the third organic pattern ELP3 and the second bank layer 163, which are spaced apart from each other. In other words, the first passivation layer 172A may be disposed in contact with the second bank layer 163, and the second passivation layer 172B may be disposed in contact with the third organic pattern ELP3.

In some embodiments, the third organic pattern ELP3 may include a first side E3a and a second side E3b. The first side E3a may be disposed at a portion overlapping the third light emission area EA3, and may be in contact with the third inorganic layer 171-3. In addition, the second side E3b may be disposed at a portion overlapping the non-light emission area NLA, and may be in contact with the third passivation layer 172C.

The third electrode pattern CEP3 according to an embodiment may be disposed in contact with the third organic pattern ELP3.

In some embodiments, the third electrode pattern CEP3 may include a first side C3a and a second side C3b. The first side C3a may be disposed at a portion overlapping the third light emission area EA3, and may be in contact with the third inorganic layer 171-3. In addition, the second side C3b may be disposed at a portion overlapping the non-light emission area NLA, and may be in contact with the third passivation layer 172C.

The second side E3b of the third organic pattern ELP3 and the second side C3b of the third electrode pattern CEP3 according to an embodiment may be exposed by the etching process during the fabricating process of the display device 10, and thus may become a permeation path of moisture and oxygen or an etching solution. However, the display device 10 according to an embodiment includes the element passivation layer 172 completely covering the second side E3b of the third organic pattern ELP3 and the second side C3b of the third electrode pattern CEP3, thereby resolving the defect caused by permeation of moisture and oxygen or the etching solution during the fabricating process of the display device 10.

FIGS. 10 to 24 are schematic cross-sectional views illustrating an embodiment of a method of fabricating a display layer DPL shown in FIG. 5. Hereinafter, the fabricating process of the display layer DPL shown in FIG. 5 according to an embodiment will be described with respect to the formation order of each layer.

Referring to FIG. 10, in an embodiment of a method of fabricating a display layer DPL, a plurality of anode electrodes AE, a sacrificial layer SFL, a pixel defining material layer 151L, and bank material layers 161L and 163L are formed on the thin film transistor layer 130. Although not shown in the drawing, the thin film transistor layer 130 may be disposed on the substrate 110, and the structure of the thin film transistor layer 130 is the same as that described above with reference to FIG. 5. Any repetitive detailed description thereof will be omitted.

The anode electrode AE may include first to third anode electrodes AE1, AE2 and AE3 disposed to be spaced apart from one another on the thin film transistor layer 130. A sacrificial layer SFL may be disposed on each of the first to third anode electrodes AE1, AE2 and AE3 such that upper surfaces of the first to third anode electrodes AE1, AE2 and AE3 are not in contact with the pixel defining material layer 151L.

The sacrificial layer SFL may include an oxide semiconductor. In an embodiment, for example, the sacrificial layer SFL may include at least one selected from indium gallium zinc oxide (IGZO), zinc tin oxide (ZTO), and indium tin oxide (IZO).

The pixel defining material layer 151L and the bank material layers 161L and 163L may be disposed on the first to third anode electrodes AE1, AE2 and AE3 and the sacrificial layer SFL. The pixel defining material layer 151L may be disposed to entirely cover the sacrificial layer SFL and the thin film transistor layer 130, and the bank material layers 161L and 163L may be disposed to entirely cover the pixel defining material layer 151L. A first bank material layer 161L may be directly disposed on the pixel defining material layer 151L, and a second bank material layer 163L may be sequentially disposed on the first bank material layer 161L.

Next, a photoresist PR is formed on the second bank material layer 163L except for a portion overlapping the first anode electrode AE1. Subsequently, a first etching process (1^{st} etching) of etching a portion of the pixel defining material layer 151L, the first bank material layer 161L and the second bank material layer 163L using the photoresist PR as a mask is performed.

In an embodiment, the first etching process (1^{st} etching) may be performed by dry etching. As the first etching process (1^{st} etching) is performed by a dry etching process, portions of the pixel defining material layer 151L and the bank material layers 161L and 163L, which overlap the first anode electrode AE1, may be isotropically etched.

Through the process, as shown in FIG. 11, a hole HOL may be formed in a portion overlapping the first anode electrode AE1, and the sacrificial layer SFL disposed on the first anode electrode AE1 may be exposed.

Subsequently, referring to FIG. 11, a second etching process (2^{nd} etching) of etching the inside of the hole HOL formed to overlap the first anode electrode AE1 is performed. In an embodiment, the second etching process (2^{nd} etching) may be performed by a wet etching process.

The second bank material layer 163L included in an embodiment may have an etching rate lower than that of the first bank material layer 161L. In other words, the second bank material layer 163L included in an embodiment may have an etching rate lower than that of the first bank material layer 161L.

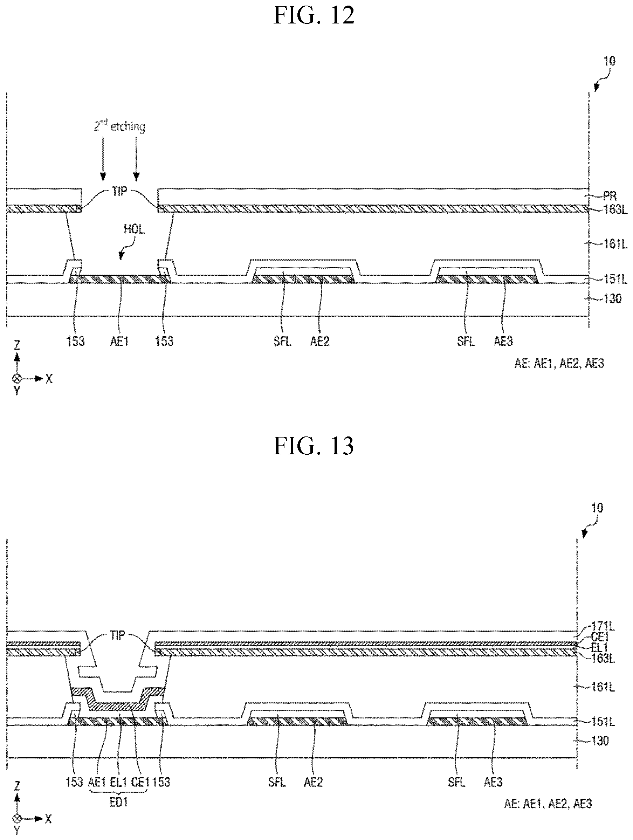

As a result, as shown in FIG. 12, the side of the second bank material layer 163L may form a tip TIP that is more protruded toward the hole HOL than the side of the first bank material layer 161L.

At the same time, a portion of the sacrificial layer SFL disposed on the first anode electrode AE1 may be removed through the second etching process (2^{nd} etching). However, the sacrificial layer SFL may not be completely removed, and may remain as a partial residual pattern 153 in the space between the pixel defining material layer 151L and the first anode electrode AE1.

Next, referring to FIG. 13, the first light emitting layer EL1 and the first cathode electrode CE1 are deposited on the first anode electrode AE1 so that the first light emitting element ED1 is formed. The first light emitting layer EL1 and the first cathode electrode CE1 according to an embodiment may be formed through a thermal deposition process. In the display device 10 according to an embodiment, as the second bank material layer 163L includes the tip TIP, the first light emitting layer EL1 and the first cathode electrode CE1 may be formed on the first anode electrode AE1 without a separate fine metal mask.

However, the deposition process of forming the first light emitting layer EL1 may be performed by being inclined at an angle in a range of about 45° to about 50° with respect to the upper surface of the first anode electrode AE1. As a result, the first light emitting layer EL1 may be formed to fill a space where the first anode electrode AE1 and the pixel defining material layer 151L are spaced apart from each other, and may be also formed on a portion of the side of the first bank material layer 161L covered by the tip TIP of the second bank material layer 163L.

The deposition process of forming the first cathode electrode CE1 according to an embodiment may be performed by being inclined at an angle of about 30° or less with respect to the upper surface of the first anode electrode AE1. In other words, the deposition process of forming the first cathode electrode CE1 may be performed by being inclined to be relatively closer to a horizontal direction than the deposition process of forming the first light emitting layer EL1. As a result, the first cathode electrode CE1 may completely cover the first light emitting layer EL1.

The first light emitting layer EL1 and the first cathode electrode CE1 according to an embodiment may be disposed not only on the first anode electrode AE1 but also on the second bank material layer 163L. In other words, the first light emitting layer EL1 and the first cathode electrode CE1 according to an embodiment may be also disposed on the second bank material layer 163L at portions overlapping the second anode electrode AE2 and the third anode electrode AE3.

Subsequently, the first encapsulation material layer 171L covering the first cathode electrode CE1 is entirely formed. The first encapsulation material layer 171L may be performed by a chemical vapor deposition (CVD) process, and the first encapsulation material layer 171L may form a uniform film (or a film having a substantially uniform or constant thickness) regardless of a step difference of the lower structure. In an embodiment, for example, the first encapsulation material layer 171L may cover a step difference formed by the first light emitting element ED1, and may cover an undercut portion formed between the first bank material layer 161L and the tip TIP of the second bank material layer 163L. In addition, the first encapsulation material layer 171L may entirely cover the first cathode electrode CE1 disposed on the second bank material layer 163L.

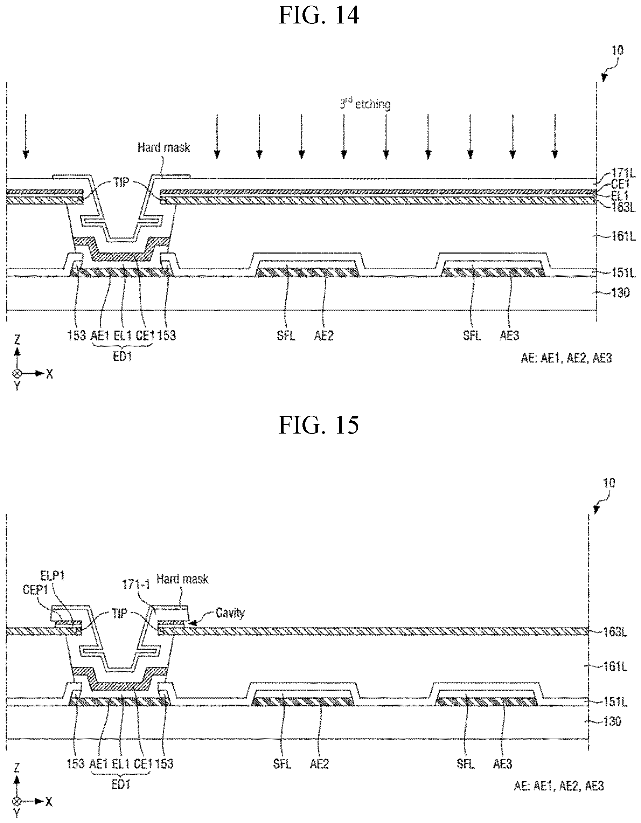

Referring to FIG. 14, a hard mask is formed at a portion overlapping the first light emitting element ED1 and the periphery of the first light emitting element ED1, and a third etching process (3^{rd} etching) of etching a portion where the hard mask is not formed is performed. In an embodiment, for example, the third etching process may be performed by a wet process. In the process, the first light emitting layer EL1, the first cathode electrode CE1 and the first encapsulation material layer 171L, at which the hard mask is not formed, may be all removed. Indium gallium zinc oxide (IGZO) may be used as the hard mask used in the third etching process (3^{rd} etching).

Referring to FIG. 15, through the process, the first inorganic layer 171-1 may be formed, and the first light emitting layer EL1 and the first cathode electrode CE1, which are disposed on the second bank material layer 163L, may be formed as the first organic pattern ELP1 and the first electrode pattern CEP1.

The first organic pattern ELP1, the first electrode pattern CEP1 and the first inorganic layer 171-1 according to an embodiment may have their respective etching rates different from one another in the third etching process (3^{rd} etching). In an embodiment, for example, the etching rates of the first organic pattern ELP1 and the first electrode pattern CEP1 may be faster than the etching rate of the first inorganic layer 171-1. That is, the first organic pattern ELP1 and the first electrode pattern CEP1 may be etched faster than the first inorganic layer 171-1. As a result, a cavity may be formed on sides of the first organic pattern ELP1 and the first electrode pattern CEP1 according to an embodiment. Portions of the first organic pattern ELP1 and the first electrode pattern CEP1 may be exposed at the portion where the cavity is formed.

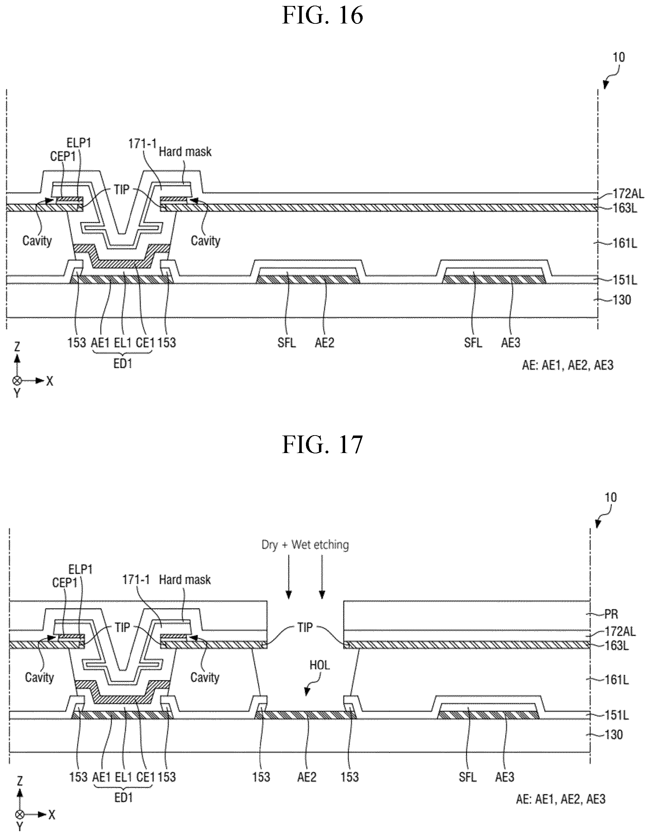

Next, referring to FIG. 16, a first element passivation material layer 172AL is entirely deposited on the hard mask. The first element passivation material layer 172AL may completely cover the first inorganic layer 171-1, and may also completely cover the portion where the cavity is formed. That is, the first element passivation material layer 172AL may completely cover the first organic pattern ELP1 and the first electrode pattern CEP1.

In the fabricating process according to an embodiment, exposed portions of the first organic pattern ELP1 and the first electrode pattern CEP1 may become paths through which moisture and oxygen or an etching solution is permeated. When oxygen and moisture or an etching solution is permeated through the first organic pattern ELP1 and the first electrode pattern CEP1, the display device 10 may have reliability defects such as occurrence of dark spots or pixel shrinkage. However, in the display device 10 according to an embodiment, the exposed portions of the first organic pattern ELP1 and the first electrode pattern CEP1 are completely covered with the first element passivation material layer 172AL, such that the reliability defects caused during the fabricating process of the display device 10 may be resolved. In an embodiment, for example, the first element passivation material layer 172AL may resolve the reliability defects of the first light emitting element ED1.

Next, referring to FIGS. 17 to 21, the above-described processes are repeated so that the second light emitting element ED2 is formed. In detail, a photoresist PR is formed such that a portion overlapping the second anode electrode AE2 is exposed, and a hole HOL is formed at a portion overlapping the second anode electrode AE2 through a dry etching process. Subsequently, a portion of the bank material layers 161L and 163L overlapping the inside of the hole HOL is wet-etched to form the tip TIP of the second bank material layer 163L.

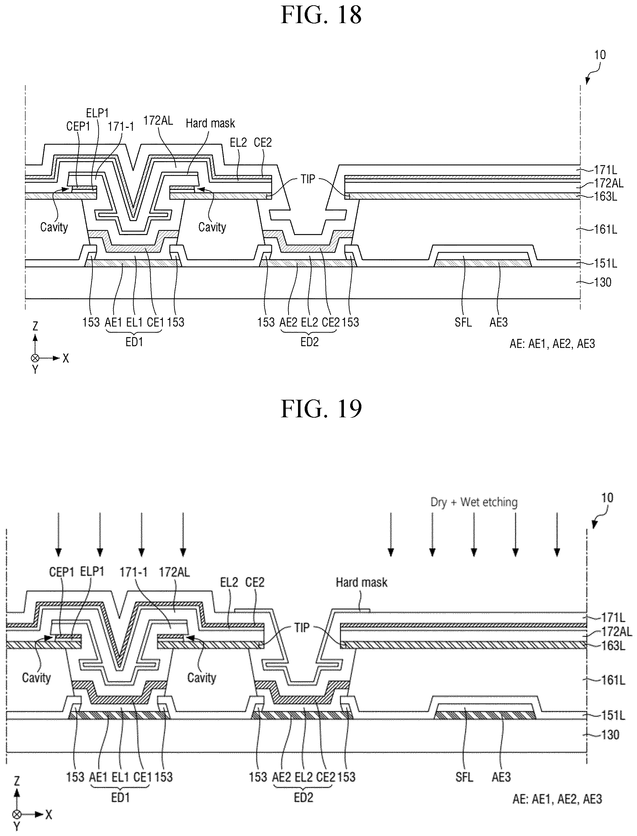

Next, referring to FIG. 18, the second light emitting layer EL2, the second cathode electrode CE2 and the first encapsulation material layer 171L are entirely deposited. In such a process, the second light emitting layer EL2, the second cathode electrode CE2 and the first encapsulation material layer 171L are formed on the second anode electrode AE2, so that the second light emitting element ED2 may be formed. In the display device 10 according to an embodiment, as the second bank material layer 163L includes the tip TIP, the second light emitting layer EL2 and the second cathode electrode CE2 may be formed on the second anode electrode AE2 even without a separate fine metal mask, as similarly to the first light emitting layer EL1 and the first cathode electrode CE1 described above with reference to FIG. 13. Furthermore, the second light emitting layer EL2, the second cathode electrode CE2 and the first encapsulation material layer 171L may be entirely formed on the first element passivation material layer 172AL.

Subsequently, referring to FIG. 19, the hard mask is formed at a portion overlapping the second light emitting element ED2 and the periphery of the second light emitting element ED2, and a portion where the hard mask is not formed is partially etched. In such a process, the second light emitting layer EL2, the second cathode electrode CE2 and the first encapsulation material layer 171L, at which the hard mask is not formed, may be all removed.

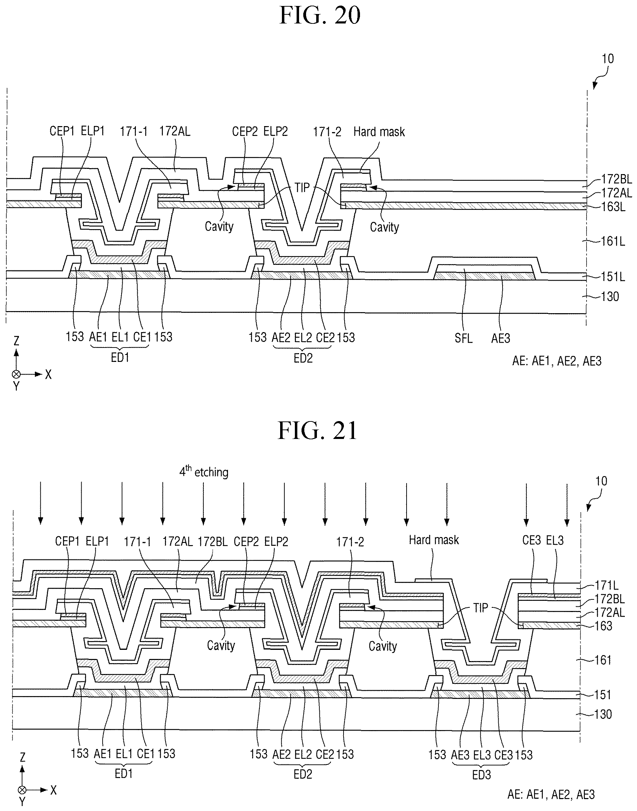

Referring to FIG. 20, the second inorganic layer 171-2, the second organic pattern ELP2 and the second electrode pattern CEP2 may be formed through processes similar to those described above with reference to FIGS. 14 and 15. As described above, since the etching rate of the second inorganic layer 171-2 is slower than the etching rates of the second organic pattern ELP2 and the second electrode pattern CEP2, a cavity may be formed on the sides of the second organic pattern ELP2 and the second electrode pattern CEP2, and portions of the second organic pattern ELP2 and the second electrode pattern CEP2, which overlaps the cavity, may be exposed. A redundant description will be omitted.

Subsequently, as shown in FIG. 20, a second element passivation material layer 172BL completely covering the exposed portions of the second organic pattern ELP2 and the second electrode pattern CEP2 is entirely deposited. The second element passivation material layer 172BL may be formed on the first element passivation material layer 172AL. The second element passivation material layer 172BL may completely cover the second inorganic layer 171-2, and may completely cover the exposed portions of the second organic pattern ELP2 and the second electrode pattern CEP2.

Therefore, the display device 10 according to an embodiment may block a path through which moisture and oxygen or an etching solution is permeated by the second organic pattern ELP2 and the second electrode pattern CEP2 during the fabricating process, such that the reliability defect caused during the fabricating process of the display device 10 may be resolved. In an embodiment, for example, the second element passivation material layer 172BL may resolve the reliability defect of the second light emitting element ED2.

Next, the above-described processes are repeated again so that the third light emitting element ED3 is formed. The process of forming the third light emitting element ED3 may be the same as the processes of forming the first light emitting element ED1 and the second light emitting element ED2. The third light emitting layer EL3, the third cathode electrode CE3 and the first encapsulation material layer 171L according to an embodiment may be formed on the third anode electrode AE3, and may be also disposed on the second element passivation material layer 172BL at portions overlapping the first anode electrode AE1 and the second anode electrode AE2. Any repetitive detailed description of the same or like elements as those described above will be omitted. Through such a process, the pixel defining material layer 151L may be formed in the form of the pixel defining layer 151, the first bank material layer 161L may be formed in the form of the first bank layer 161, and the second bank material layer 163L may be formed in the form of the second bank layer 163.

Subsequently, the hard mask is formed at a portion overlapping the third light emitting element ED3 and the periphery of the third light emitting element ED3, and a fourth etching process (4^{th} etching) of etching a portion where the hard mask is not formed is performed. In an embodiment, for example, the fourth etching process (4^{th} etching) may be performed in such a manner that the wet process and the dry etching process are alternately performed.

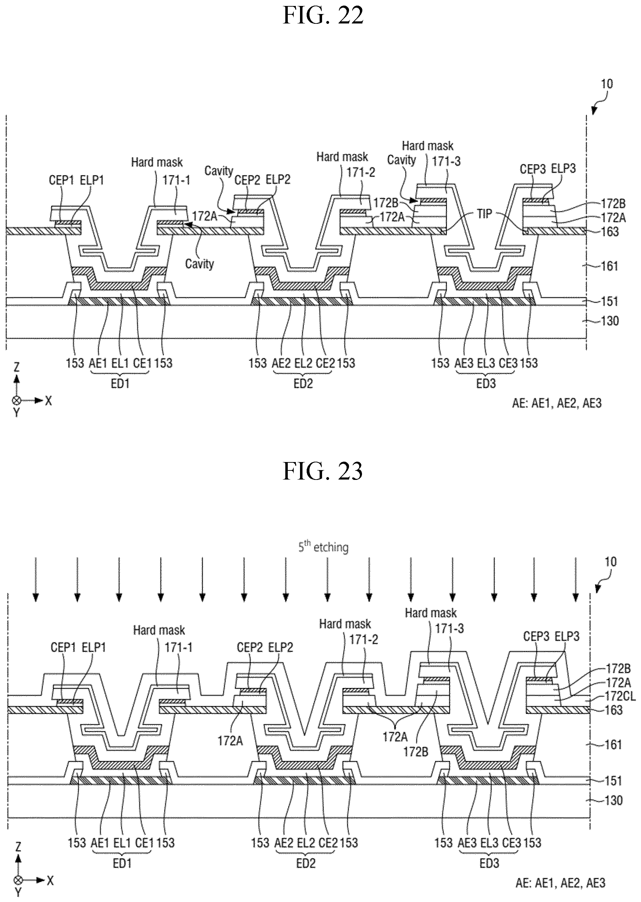

Referring to FIG. 22, the third light emitting layer EL3, the third cathode electrode CE3 and the first encapsulation material layer 171L, at which the hard mask is not formed, may be all removed. In addition, the first element passivation material layer 172AL and the second element passivation material layer 172BL, which are disposed above the hard mask to respectively overlap the first anode electrode AE1 and the second anode electrode AE2, may be all removed.

Through such a process, the first inorganic layer 171-1, the second inorganic layer 171-2 and the third inorganic layer 171-3, which are included in the first encapsulation layer 171, may be formed, the third organic pattern ELP3 and the third electrode pattern CEP3 may be formed, and the first passivation layer 172A and the second passivation layer 172B, which are included in the element passivation layer 172, may be formed. The first passivation layer 172A may be formed as the first element passivation material layer 172AL is subjected to the etching process, and the second passivation layer 172B may be formed as the second element passivation material layer 172BL is subjected to the etching process.

In this process, a cavity may be formed at portions where each of the first to third inorganic layers 171-1,171-2 and 171-3 and the first to third organic patterns ELP1, ELP2 and ELP3 and the first to third electrode patterns CEP1, CEP2 and CEP3 overlap one another. For this reason, the first to third organic patterns ELP1, ELP2 and ELP3 and the first to third electrode patterns CEP1, CEP2 and CEP3 may be partially exposed.

Next, referring to FIG. 23, a third element passivation material layer 172CL is entirely deposited above the hard mask overlapping the first to third anode electrodes AE1, AE2 and AE3. The third element passivation material layer 172CL may completely cover the exposed portions of the first to third organic patterns ELP1, ELP2 and ELP3 and the first to third electrode patterns CEP1, CEP2 and CEP3. As a result, the third element passivation material layer 172CL according to an embodiment may prevent moisture and oxygen or an etching solution from being permeated through the first to third organic patterns ELP1, ELP2 and ELP3 and the first to third electrode patterns CEP1, CEP2 and CEP3.

Subsequently, a fifth etching process (5^{th} etching) is performed using the hard mask disposed to overlap the first to third anode electrodes AE1, AE2 and AE3 as a mask. In an embodiment, for example, the fifth etching process (5^{th} etching) may be a dry etching process. Through such a process, the third element passivation material layer 172CL that does not overlap the hard mask may be fully removed.

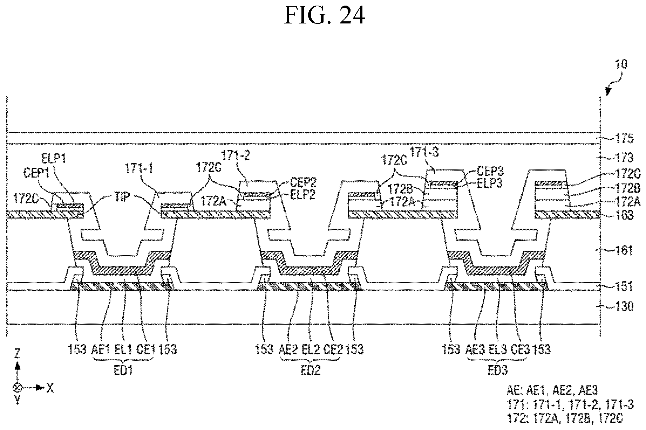

Referring to FIG. 24, the third element passivation material layer 172CL may be formed in a same shape as that of the third passivation layer 172C shown in FIG. 5 through the aforementioned process, and thus, the element passivation layer 172 may include a first passivation layer 172A, a second passivation layer 172B, and a third passivation layer 172C. The third passivation layer 172C may be in contact with a portion of the first to third organic patterns ELP1, ELP2 and ELP3 and a portion of the first to third electrode patterns CEP1, CEP2 and CEP3. In other words, the third passivation layer 172C may completely cover sides of the first to third organic patterns ELP1, ELP2 and ELP3 and sides of the first to third electrode patterns CEP1, CEP2 and CEP3.

In the display device 10 according to an embodiment, the first to third light emitting elements ED1, ED2 and ED3 are formed in different processes by the first to third organic patterns ELP1, ELP2 and ELP3 and the first to third electrode patterns CEP1, CEP2 and CEP3, which are disposed on different layers. In addition, in the display device 10 according to an embodiment, the first passivation layer 172A, the second passivation layer 172B and the third passivation layer 172C are formed in different layers by different processes.

Subsequently, the second encapsulation layer 173 is entirely formed and the third encapsulation layer 175 is entirely formed on the second encapsulation layer 173, so that the step difference included in the first encapsulation layer 171 may be planarized, such that the display element layer 150 and the thin film encapsulation layer 170 of the display device 10 shown in FIG. 5 may be formed.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate including a light emission area and a non-light emission area;
an anode electrode on the light emission area of the substrate;
a light emitting layer on the anode electrode;
a pixel defining layer on the non-light emission area of the substrate, wherein the pixel defining layer defines a first opening;
a bank structure including first and second bank layers positioned on the pixel defining layer, wherein the first and second bank layers define a second opening and include different conductive materials, respectively;
an organic pattern on the bank structure, wherein the organic pattern includes a same material as the light emitting layer and is spaced apart from the light emitting layer;
a first encapsulation layer on the organic pattern; and
an element passivation layer overlapping the non-light emission area and between the bank structure and the first encapsulation layer in a direction perpendicular to the substrate,
wherein the organic pattern includes a first side overlapping the light emission area and in contact with the first encapsulation layer, and a second side overlapping the non-light emission area and in contact with the element passivation layer.

2. The display device of claim 1, further comprising:
a cathode electrode on the light emitting layer,
wherein the light emitting layer and the cathode electrode are in contact with a side of the first bank layer, and
the second bank layer includes a tip more protruded toward the light emission area than a side of the first bank layer.

3. The display device of claim 2, further comprising:
an electrode pattern on the organic pattern, wherein the electrode pattern includes a same material as the cathode electrode, and is spaced apart from the cathode electrode.

4. The display device of claim 3, wherein the electrode pattern includes a third side overlapping the light emission area and in contact with the first encapsulation layer, and a fourth side overlapping the non-light emission area and in contact with the element passivation layer, optionally wherein the second side of the organic pattern and the fourth side of the electrode pattern are completely covered by the element passivation layer.

5. The display device of any one of claims 1 to 4, wherein the first opening is completely surrounded by the second opening on a plane.

6. The display device of any one of claims 1 to 5, further comprising:
a second encapsulation layer including an organic material on the first encapsulation layer,
wherein the element passivation layer is in contact with the first encapsulation layer and the second encapsulation layer by overlapping the non-light emission area, optionally wherein the element passivation layer is completely covered by the first encapsulation layer and the second encapsulation layer.

7. The display device of any one of claims 2 to 6, wherein
a height of the first bank layer is higher than a height of the second bank layer in a direction perpendicular to the substrate, and
an electrical conductivity of the first bank layer is higher than an electrical conductivity of the second bank layer, optionally wherein
the first bank layer includes aluminium, and
the second bank layer includes titanium.

8. The display device of any one of claims 1 to 7, wherein:
(i) the element passivation layer includes at least one selected from silicon oxide, silicon oxynitride and silicon nitride; and/or
(ii) the organic pattern is in contact with the second bank layer, and
the element passivation layer does not overlap the light emission area.

9. The display device of any one of claims 2 to 8, wherein the element passivation layer includes a first passivation layer in contact with a second side of the organic pattern, and a second passivation layer between the organic pattern and the second bank layer in a direction perpendicular to the substrate.

10. The display device of claim 9, wherein the first passivation layer does not overlap the light emission area,
the second passivation layer overlaps the light emission area, and
the second passivation layer is in contact with the second bank layer, optionally wherein:
the element passivation layer further includes a third passivation layer between the second passivation layer and the organic pattern in a direction perpendicular to the substrate, and
the second passivation layer and the third passivation layer overlap a tip of the second bank layer.

11. A display device comprising:
a substrate including a light emission area and a non-light emission area;
a first anode electrode on the light emission area of the substrate;
a first light emitting layer on the first anode electrode;
a pixel defining layer on the non-light emission area of the substrate;
a second anode electrode spaced apart from the first anode electrode with the pixel defining layer interposed therebetween;
a second light emitting layer on the second anode electrode;
a bank structure on the pixel defining layer, wherein the bank structure includes a first bank layer and a second bank layer;
a first organic pattern on the second bank layer, wherein the first organic pattern includes a same material as the first light emitting layer and is spaced apart from the first light emitting layer;
a second organic pattern spaced apart from the first organic pattern in a direction parallel with the substrate, wherein the second organic pattern includes a same material as the second light emitting layer and is spaced apart from the second light emitting layer;
a first encapsulation layer on the first organic pattern and the second organic pattern;
a second encapsulation layer on the first encapsulation layer; and
an element passivation layer between the first encapsulation layer and the second bank layer in a direction perpendicular to the substrate,
wherein a portion of the element passivation layer, which is in contact with first organic pattern, and another portion of the element passivation layer, which is in contact with the second organic pattern, are spaced apart from each other in a direction parallel with the substrate.

12. The display device of claim 11, further comprising:
a first cathode electrode on the first light emitting layer; and
a second cathode electrode on the second light emitting layer,
wherein the first cathode electrode and the second cathode electrode are electrically connected to each other through the first bank layer.

13. The display device of claim 12, wherein the element passivation layer includes a first passivation layer in contact with the first organic pattern, and a second passivation layer in contact with the second organic pattern,
an upper surface of the second bank layer, which is directed toward the second encapsulation layer, includes:
a first portion in contact with the first organic pattern;
a second portion in contact with the second passivation layer;
a third portion in contact with the first passivation layer; and
a fourth portion in contact with the second encapsulation layer.

14. The display device of claim 12, wherein the element passivation layer includes a first passivation layer overlapping the first organic pattern in a direction perpendicular to the substrate; and
a second passivation layer in contact with the second organic pattern,
the second bank layer includes a first portion in contact with the first passivation layer, a second portion in contact with the second passivation layer and a third portion in contact with the second encapsulation layer.

15. A method of fabricating a display device, the method comprising:
forming a substrate including a light emission area and a non-light emission area, forming an anode electrode on the light emission area of the substrate, forming a sacrificial layer on the anode electrode, and forming a pixel defining material layer, a first bank material layer and a second bank material layer, which completely cover the sacrificial layer and the substrate;
by forming a photoresist on the second bank material layer and forming a hole for exposing the sacrificial layer by removing a portion of the pixel defining material layer, a portion of the first bank material layer and a portion of the second bank material layer, which overlaps the anode electrode, through an etching process and then removing the sacrificial layer by removing an inner sidewall defining the hole through an etching process, to form a pixel defining layer, a first bank layer, and a second bank layer, wherein the second bank material layer forms a tip, which is more protruded toward the hole than a side of the first bank material layer;
forming a first light emitting element by forming a light emitting layer, a cathode electrode and a first encapsulation layer on the anode electrode and the second bank layer, forming a hard mask at a portion overlapping the light emission area and a periphery of the light emission area, and removing the light emitting layer, the cathode electrode and the first encapsulation layer, which are positioned at a portion where the hard mask is not formed, through a wet etching process to form a first organic pattern and a first electrode pattern on the second bank layer; and
forming an element passivation layer entirely on the hard mask, and removing the element passivation layer through an etching process using the hard mask as a mask,
wherein the element passivation layer completely covers the first organic pattern and the first electrode pattern such that the first organic pattern and the first electrode pattern are not exposed.
